# EUROPEAN PATENT APPLICATION

(11) **EP 0 766 302 A2**
(43) Date of publication of application: **02.04.1997**
(21) Application number: 96115276.6
(22) Date of filing: 24.09.1996
(51) Int. Cl.: H01L 21/768, H01L 21/285

(54) **Process for fabricating a CVD aluminium layer in a semiconductor device**

(30) Priority: 27.09.1995 US 534367
(71) Applicant: MOTOROLA, INC., Schaumburg, IL 60196 (US)
(72) Inventor: Fiordalice, Robert W., Austin, Texas 78704 (US); Kawasaki, Hisao, Austin, Texas 78759 (US); Blumenthal, Roc, Austin, Texas 78759 (US)
(74) Representative: Hudson, Peter David

(57) **Abstract**

A process for fabricating a CVD aluminum layer in a semiconductor device includes the formation of a chemical vapor deposited metal layer (38) overlying a composite nucleation layer (32). The composite nucleation layer (32) includes a sputter deposited titanium layer (34) underlying a sputter deposited aluminum layer (36). Both the composite nucleation layer and the chemical vapor deposited metal layer are processed in an inert atmosphere and their high vacuum condition such that exposure of metal surfaces to atmospheric oxygen is avoided during the multi-level metal process. The chemical vapor deposit metal layer (38) exhibits the high specularity and low surface roughness of the underlying sputter deposited composite nucleation layer (32).

## Description

### Field of the Invention

This invention relates, in general, to a method for fabricating a semiconductor device, and more particularly, to a method for fabricating a chemical vapor deposited metal layer having high specularity and low surface roughness.

### Background of the Invention

As the complexity of integrated circuit devices continues to increase, the use of multiple layers of metal interconnects is necessary to provide electrical interconnection to the large number of device components in an integrated circuit. The increased complexity of integrated circuit devices is achieved, in part, by reducing device feature sizes and spacing. Among the features which are reduced in size are the width and spacing of interconnecting metal lines and the via openings through which the metal lines make electrical contact to one another, and to device regions in the substrate. As the feature sizes are reduced, new problems arise which must be solved in order to economically and reliably produce semiconductor devices.

A reduction in device feature size is often accompanies by a concomitant increase in the aspect ration of via openings. The aspect ratio of a via opening is defined as the depth of the opening divided by the width of the opening. As the aspect ratio of a via opening increases, new device metallization processes are required to achieve adequate bottom surface coverage in the via. Conventional chemical vapor deposition (CVD) processes have failed to provide a metal film having sufficient conformality to completely cover the bottom surface of a high aspect ratio via. Furthermore, conventional physical vapor deposition (PVD) or sputtering techniques have also failed to provide adequate metal coverage of the sidewalls and bottom surface in a high aspect ratio via. Accordingly, a typical method for forming a via in a very-large-scale integration (VLSI) device is to form a refractory metal plug in the via using a combination of chemical vapor deposition and planarization processes. Once the via plug is formed, conventional deposition techniques, such as CVD and PVD, can be used to deposit a metal layer over the plug.

While the via plug process is an effective method for forming a metal interconnect through a high aspect ratio via, the process is complex and requires the use of a refractory metal, such as tungsten, which has a different electrical conductivity than that of aluminum alloys typically used for metal interconnects. The disparity in electrical conductance characteristics can lead to the formation of voids in the metal interconnect structure as a result of electromigration and other phenomenon.

Current techniques used to provide improved metal interconnects and minimizing process complexity include a combination of PVD deposited metal and CVD deposited metal. The combination is advantageous because the PVD deposition process provides a method of depositing a nucleation layer on a dielectric surface. The CVD process is an isotropic deposition process and thus possesses desirable characteristics for the filling of via opening. However, a major drawback to the use of CVD deposited metal is the low specularity and high degree of surface roughness obtained from a conventional CVD process. The low specularity and high surface roughness makes it difficult to apply the high resolution photolithography to the CVD deposited metal layer necessary to form metal fine line interconnects for VLSI devices.

In order to obtain a more usable CVD deposited metal film, various underlying PVD material layers have been developed for use in conjunction with CVD. However, the underlying PVD films of the prior art have failed to enhance the specularity and surface roughness of an overlying CVD deposited metal film to an extent necessary to obtain high resolution, fine line interconnect patterns. Accordingly, a need existed for an improved processing method for the fabrication of a metal film having high specularity and low surface roughness.

### Summary of the Invention

In practicing the present invention there is provided a process for fabricating a CVD aluminum layer in a semiconductor device in which a CVD aluminum film is formed having high specularity and low surface roughness. The CVD deposited aluminum film formed in accordance with the invention can be patterned by high resolution photolithographic techniques to form fine metal interconnect leads in an integrated circuit device. In one embodiment of the invention, a substrate is provided having a dielectric layer thereon. The substrate is placed in an inert atmosphere and a titanium film is sputtered onto the dielectric layer. Then, a first aluminum film is sputtered onto the titanium film while maintaining the substrate in an inert atmosphere. A chemical vapor deposited second aluminum layer is formed on the first aluminum film, wherein the second aluminum film is in intimate contact with the first aluminum film. The process of the invention propagates the specularity and surface roughness of the first aluminum film throughout the second aluminum film yielding a chemical vapor deposited aluminum layer having high specularity and low surface roughness.

### Brief Description of the Drawings

FIG. 1 is a schematic diagram of a multi-chambered deposition apparatus useful for performing the present invention;
FIGs. 2-3 illustrate, in cross-section, process steps in accordance with the invention;
FIG. 4 is a plot of reflectivity versus aluminum thickness for metal films formed in accordance with the invention and in accordance with the prior art; and
FIG. 5 is a plot of surface roughness versus metal composition for processes of the prior art and for the process of the invention.

It will be appreciated that for simplicity and clarity of illustration, elements shown in the FIGURES have not necessarily been drawn to scale. For example, the dimensions of some of the elements are exaggerated relative to each other. Further, where considered appropriate, reference numerals have been repeated among the FIGURES to indicate corresponding elements.

### Detailed Description of Preferred Embodiments

The present invention provides a process or the fabrication of a metal layer having high film specularity (mirror-like quality) and low surface roughness. The process of the invention further provides a method for conformally depositing the metal layer so as to fill openings having high aspect ratios. A metal film formed in accordance with the invention can be patterned by high-resolution lithography techniques to form fine metal leads in integrated circuit devices. Additionally, the high degree of metal step coverage provided by the invention eliminates the need for refractory metal plugs in multi-level metal devices. Both improved reflectivity and low surface roughness are obtained by forming a compound nucleation layer upon which a metal interconnect is formed. The advantages of the present invention can be more fully understood following a description of a preferred process embodiment in which all processing steps are carried out under vacuum, and under an inert atmosphere.

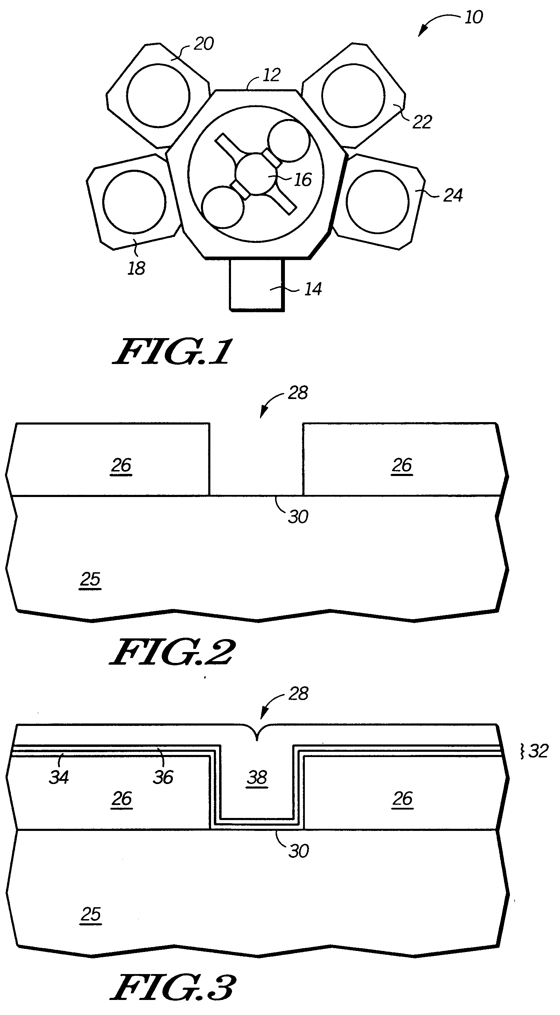

Shown in FIG. 1 is a schematic diagram of an exemplary processing apparatus 10 useful for practicing the present invention. Processing apparatus 10 includes a transfer chamber 12 surrounded by a plurality of processing chambers. A load lock 14 is provided to transfer semiconductor wafers in and out of transfer chamber 12. Within transfer chamber 12, a wafer transport mechanism 16 transfers semiconductor substrates to the various processing chambers surrounding transfer chamber 12.

In the schematic diagram illustrated in FIG. 1, a first processing chamber 18 resides adjacent to transfer chamber 12 in a clockwise direction from load lock chamber 14. Second, third and fourth processing chambers 20, 22, and 24, respectively, reside adjacent to transfer chamber 12 in a clockwise direction from first processing chamber 18. All processing chambers can be accessed through vacuum sealed doors (not shown) located in the wall between each processing chamber and transfer chamber 12. Wafer transfer mechanism 16 can rotate so as to align itself with each processing chamber for the transfer of a semiconductor substrate into a processing chamber, and load lock chamber 14. Each chamber in processing apparatus 10 can be independently evacuated to a desired pressure through vacuum lines and independent vacuum pumps (not shown) attached to each chamber. Additionally, each processing chamber is independently supplied with processing gases (not shown) as necessary to perform the intended processes.

The arrangement of multiple processing chambers around a central transfer chamber permits semiconductor substrates to be transferred from one processing chamber to the next without exposing the semiconductor substrates to ambient atmospheric conditions. This is an important aspect of the present invention because a number of metals commonly used in the fabrication of semiconductor devices rapidly react with oxygen in the ambient atmosphere to form oxide layers on exposed metal surfaces. The formation of oxide layers on exposed metal surfaces is undesirable because an oxide layer can prevent the nucleation of a new metal layer upon a previously-formed exposed metal surface. Additionally, oxides of metals commonly used in semiconductor fabrication are not electrically conductive and their formation leads to increased electrical resistance at metal junctions formed during device fabrication.

FIG. 2 illustrates, in cross-section, a portion of a semiconductor substrate 25 having already undergone several steps in accordance with the invention. A dielectric layer 26 overlies the surface of semiconductor substrate 25. An opening 28 exposes a surface portion 30 of semiconductor substrate 25. For purposes of illustration, the cross-sectional representation of semiconductor substrate 25 has been substantially simplified. The present invention contemplates the formation of opening 28 in a variety of dielectric materials employed in various stages of semiconductor device processing. Additionally, although semiconductor substrate 25 is illustrated as a continuous body, it is intended that semiconductor substrate 25 generally represent a semiconductor device at many different stages during semiconductor device fabrication. For example, dielectric layer 26 can be a first dielectric layer applied over transistors, and capacitors, and the like, formed in a first conductive level of a semiconductor device, or alternatively, an interlevel dielectric (ILD) layer formed over a first metal layer overlying many transistor devices, capacitor devices, resistors, and the like. Furthermore, opening 28 can be an opening exposing a portion of a single crystal silicon substrate, or a refractory-metal silicide region formed in a single crystal silicon body, and the like. Additionally, surface portion 30 can be a portion of a patterned metal lead for the purposes of forming a via opening between multiple metal layers.

As illustrated in FIG. 3, after forming opening 28, a composite nucleation layer 32 is formed to overlie dielectric layer 26 and surface portion 30. Preferably, composite nucleation layer 32 is comprised of a sputtered titanium layer 34 and an overlying a sputtered aluminum layer 36.

Composite nucleation layer 32 provides a surface having high specularity and low surface roughness overlying dielectric layer 26 and opening 28. In accordance with the invention, composite nucleation layer 32 is employed to nucleate the formation of an aluminum metal layer 38 preferably formed by chemical vapor deposition. During the chemical vapor deposition process, aluminum atoms adhere to the surface of nucleation layer 32 in successive layers. As aluminum metal layer 38 grows, the high specularity and low surface roughness of composite nucleation layer 32 is propagated throughout aluminum metal layer 38. Upon completion of the chemical vapor deposition process, aluminum metal layer 38 exhibits the same high specularity and low surface roughness as underlying composite nucleation layer 32. Additionally, because of the isotropic deposition characteristics of the chemical vapor deposition process, opening 28 is completely filled with the chemical vapor deposited metal.

The high specularity and low surface roughness of aluminum metal layer 38, enables the application of high resolution lithographic techniques to pattern aluminum metal layer 38 into fine metal leads interconnecting the various functional components of a complex integrated circuit. Additionally, the process of the invention permits the complete filling of high-aspect ratio openings, such as opening 28 to form metal interconnects in multi-level metal devices.

The ability of composite nucleation layer 32 to propagate its morphological properties into an overlying CVD deposited metal layer is dependent upon complete processing of the various metal layers in an inert, high-vacuum environment. A preferred process is illustrated with reference to processing apparatus 10 illustrated in FIG. 1. After forming opening 28, semiconductor substrate 25 is transported into transfer chamber 12 through load lock chamber 14. An initial etching process can be carried out in first processing chamber 18 to remove oxides from the surface portion 30. The initial etching process may or may not be necessary depending upon the particular electrical interconnect structure being fabricated. Next, semiconductor substrate 25 is transferred by wafer transfer mechanism 16 into second processing chamber 20 and titanium layer 34 is deposited by PVD deposition onto semiconductor substrate 25. In a preferred embodiment, titanium layer 34 is sputter deposited to a thickness of about 200 to 500 angstroms at a temperature of less than about 200°C.

The process continues by transferring semiconductor substrate 25 from second processing chamber 20 into third processing chamber 22 using wafer transfer mechanism 16. In third processing chamber 22, a layer of aluminum is PVD deposited onto titanium layer 34. In a preferred embodiment, aluminum layer 36 is a sputter deposited aluminum-copper alloy having about 0.5 to 2.0 weight percent copper. It is important to note that the PVD process again deposits a conformal layer of metal having a uniform thickness overlying all surfaces of semiconductor substrate 25. In a preferred embodiment, aluminum layer 36 is sputtered to a thickness of about 400 to 600 angstroms.

In a final deposition step, semiconductor substrate 25 is transferred from third processing chamber 22 into fourth processing chamber 24. In fourth processing chamber 24, a CVD deposition process is carried out to deposit aluminum metal layer 38 onto composite nucleation layer 32. Upon completion of the CVD deposition step, semiconductor substrate 25 is returned to ambient surroundings through load lock chamber 14.

It is important to note that in all stages of the foregoing multi-layer metal deposition process, semiconductor substrate 25 is maintained under high vacuum conditions, and in addition, under inert atmospheric conditions in the PVD deposition chambers. By performing all deposition steps and transfer steps under high vacuum, the formation of oxide layers on any exposed metal surface is avoided. By preventing oxide formation, the pristine surface of each metal layer is maintained throughout the multi-step metal deposition process of the invention.

The PVD process is carried out in second and third processing chambers 20 and 22, can be performed by a variety of sputtering methods. For example, titanium layer 34 and aluminum layer 36 can be deposited by conventional sputtering at processing pressures ranging from 1 to 20 millitorr using target powers ranging from 100 to 20,000 watts and temperature conditions varying from about 0 to about 500°C. Preferably, the sputtering process is carried out in an argon ambient atmosphere. Alternatively, xenon or krypton gas ambient can be used. Alternatively, the sputtering system can be an inductively coupled plasma (ICP) sputtering device operating at a coil frequency of 400 kilohertz to 60 megahertz and a pedestal frequency of 0 to 600 megahertz. The target in the ICP device is powered with about 500 to 20,000 watts RF power and the chamber is maintained at 5 to 100 millitorr in a temperature of about 20 to 500°C. Additionally, an electron cyclotron resonance (ECR) sputtering process can be used, operating at about 2.45 gigahertz with magnetic coils generating a flux density of about 875 Gauss. The ECR process is carried out at a chamber pressure of about 0.2 to about 5.0 millitorr and a temperature of 0 to 400°C. Additionally, microwave power is input from about 50 to 2,000 watts RF.

The CVD process used to form aluminum metal layer 38 is preferably carried out at about 215 to about 325°C at a chamber pressure of about 500 millitorr to about 60 torr. Preferably, the metal precursor dimethyl aluminum hydride (DMAH) is employed to deposit an aluminum film in fourth processing chamber 24. Alternatively, other precursors can be used, such as triisobutyl aluminum, trimethyl aluminum, dimethyl aluminum alane, triethyl aluminum, aluminum monochloride, and the like. Additionally, all of the foregoing precursors can be complexed with copper in varying concentrations to form an aluminum-copper alloy.

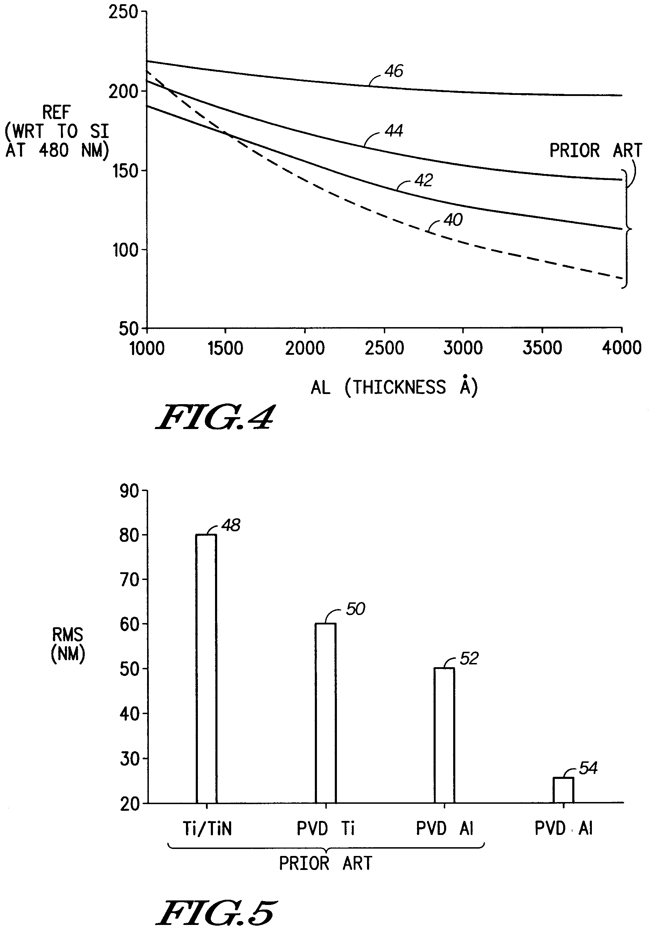

FIG. 4 is a plot of reflectivity versus aluminum thickness for three processes of the prior art and for the process of the present invention. The vertical axis is a scaled reference number in which reflectivity is measured relative to a pure single crystal silicon reference standard measured at a wave length of 480 nanometers. The horizontal axis represents the thickness of the CVD deposited aluminum layer over various nucleation layers of the prior art in comparison with that of the invention. The reflectivity measurements were carried out with a model FT 750 reflectometer manufactured by Prometrix, Corp. of Santa Clara, California. Plotted lines 40, 42 and 44 represent reflectance as a function chemical vapor deposited aluminum thickness for three different processes of the prior art. In comparison, line 46 represents a plot of reflectance versus chemical vapor deposited aluminum thickness for the process of the present invention.

Line 40 shows reflectance characteristics for chemical vapor deposited aluminum over a underlying composite layer of titanium and titanium nitride. The titanium has a thickness of 400 angstroms and the titanium nitride has a thickness of 800 angstroms. Line 42 represents reflectance characteristics of chemical vapor deposited aluminum over 1,000 angstroms of sputtered aluminum, and line 44 represents reflectance characteristics of chemical vapor deposit aluminum over 400 angstroms of titanium. As indicated by the plot of FIG. 4, a chemical vapor deposited film formed in accordance with the present invention shows a substantial increase in reflectance relative to the various prior art processes illustrated. The reflectance data illustrated by line 46 is taken from chemical vapor deposited aluminum over a composite nucleation layer of 400 angstroms of titanium underlying 500 angstroms of sputtered aluminum.

Shown in FIG. 5 is a plot of surface roughness of a CVD aluminum film versus underlying metal composition for processes of the prior art in comparison with the processes of the invention. The vertical access is the route mean square of the surface profile in nanometers. The horizontal axis represents data points for the three processes of the prior art illustrated in FIG. 4, and for the process of the invention. The surface profiles were obtained using a Nanoscope III atomic force microscope manufactured by Digital Instuments, Inc. of Santa Barbara, California.

The metal compositions of the prior art shown in FIG. 5 are identical to that illustrated in FIG. 4. For example, data point 48 represents the route mean square of surface roughness for a CVD deposited aluminum film over an underlying film of 800 angstroms of titanium nitride over 400 angstroms of titanium. Data point 50 represents the root mean square of the surface roughness of a CVD deposited aluminum film over 400 angstroms of titanium, and data point 52 illustrates the root mean square of the surface roughness of a CVD deposited aluminum layer over 1,000 angstroms of sputtered aluminum. The root mean square of the surface roughness for the process of the present invention is illustrated by data point 54. As indicated by the plot shown in FIG. 5, the root mean square of the surface roughness of an aluminum film fabricated in accordance with the invention is substantially less than that of the aluminum layers formed in accordance with the prior art.

Those skilled in the art will appreciate that a distinct advantage of the present invention is the potential for the fabrication of an aluminum layer in high aspect ratio via openings for the purposes of interconnecting metal layers in multi-level metal devices without the need for forming a refractory metal plug, such as a tungsten plug. This offers several advantages for contact formation in VLSI integrated circuits. The elimination of the necessity for forming a tungsten metal plug dramatically reduces the complexity of a multi-level metal process. The articulation technique of the present invention enables the filling of high aspect ratio vias directly with aluminum rather than performing multiple processing steps to form a refractory metal plug in the via openings. Additionally, the low degree of surface roughness and high specularity realized in an aluminum metal layer formed in accordance with the invention enables fine line lithographic techniques to be employed in order to pattern the chemical vapor deposited metal into interconnects having extremely small feature sizes.

Thus it is apparent that there has been provided, in accordance with the invention, a process for fabricating a CVD aluminum layer in a semiconductor device which fully meets the advantages set forth above. Although the invention has been described and illustrated with reference to specific illustrative embodiments thereof, it is not intended that the invention be limited to those illustrative embodiments. Those skilled in the art will recognize that variations and modifications can be made without departing from the spirit of the invention. For example, different aluminum metal alloys such as aluminum-silicon, and aluminum-silicon-copper, and the like can be formed by the process of the invention. It is therefore intended to include within the invention all such variations and modifications as fall within the scope of the appended claims and equivalents thereof.

## Claims

1. A process for fabricating a CVD aluminum layer in a semiconductor device comprising the steps of:
providing substrate having a dielectric layer thereon;
placing the substrate in an inert atmosphere;
sputtering a titanium film on the dielectric layer in the inert atmosphere;
sputtering a first aluminum film on the titanium film in the inert atmosphere; and
chemical vapor depositing a second aluminum film onto the first aluminum film in the inert atmosphere,
wherein the second aluminum film is in intimate contact with the first aluminum film.

2. The process of claim 1 wherein the step of placing the substrate in an inert atmosphere comprises placing the substrate in an atmosphere selected from the group consisting of argon, krypton, and xenon.

3. The process of claim 1, wherein the step of sputtering a titanium film comprises sputtering a titanium film to a first thickness and the step of sputtering a first aluminum film to a second thickness, and wherein the first thickness is less than the second thickness.

4. The process of claim 1 further comprising the step of:
forming an opening in the dielectric layer prior to the step of placing the substrate in an inert atmosphere,
wherein the opening is characterized by substantially vertical sidewalls and a bottom surface, and
wherein the first aluminum layer overlies the sidewalls and the bottom surface, and
wherein the second aluminum layer fills the opening.

5. The process of claim 1, wherein the step of sputtering a first aluminum layer comprises sputtering an aluminum-copper alloy.

6. The process of claim 1, wherein the step of placing the substrate in an inert atmosphere, comprises placing the substrate in a multi-chambered deposition apparatus.

7. The process of claim 1 further comprising the steps of:
providing the multi-chamber deposition apparatus having a plurality of deposition chambers adjacent to a common transfer chamber, wherein each deposition chamber is maintained under an inert atmosphere, and wherein the common transfer chamber is maintained under vacuum;
placing the substrate into a first deposition chamber to sputtering the titanium film onto the dielectric layer;
transferring the substrate through the transfer chamber to a second deposition chamber to sputter the first aluminum film on the titanium film; and
transferring the substrate through the transfer chamber to a third deposition chamber to deposit the second aluminum film by chemical vapor deposition onto the first aluminum film.
